(19) Europäisches Patentamt
European Patent Office
Office européen des brevets

(11) **EP 2 738 629 A1**

(12) **DEMANDE DE BREVET EUROPEEN**

(43) Date de publication:
**04.06.2014 Bulletin 2014/23**

(51) Int Cl.:
***G04G 3/02*** (2006.01)

(21) Numéro de dépôt: **13191860.9**

(22) Date de dépôt: **07.11.2013**

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**

(30) Priorité: **30.11.2012 EP 12195077**

(71) Demandeur: **EM Microelectronic-Marin SA
2074 Marin (CH)**

(72) Inventeurs:
• **Godat, Yves
2087 Cornaux (CH)**
• **Jeannet, Nicolas
2019 Chambrelien (CH)**

(74) Mandataire: **Surmely, Gérard et al
ICB
Ingénieurs Conseils en Brevets
Faubourg de l'Hôpital 3
2001 Neuchâtel (CH)**

(54) **Mouvement horloger électronique de haute précision et procédé de réglage d'une base de temps**

(57) Procédé de réglage d'une base de temps (4) par inhibition d'impulsions d'horloge fournies par un circuit d'horloge (8), ce procédé comprenant les étapes suivantes :
- sélectionner une période d'inhibition (P) ;
- déterminer un premier nombre N d'impulsions d'horloge à supprimer par période d'inhibition (P) pour régler sur chaque période d'inhibition le nombre d'impulsions d'horloge activant un circuit diviseur de fréquence (10) de manière que la fréquence de la base de temps s'approche au plus près d'une fréquence unité de référence ;
- sélectionner une pluralité K de sous-périodes (P1) pour chaque période d'inhibition (P) ;
- supprimer dans chaque sous-période (P1) un deuxième nombre N1 d'impulsions d'horloge correspondant au résultat de la division entière du premier nombre par le nombre de sous-périodes (N1= INT[N/K]), et
- supprimer en plus dans chaque période d'inhibition un troisième nombre N2 d'impulsions d'horloge correspondant au reste de ladite division entière (N2 = N modulo K).

Fig. 3

EP 2 738 629 A1

**Description**

<u>Domaine technique</u>

La présente invention concerne le domaine des mouvements horlogers électroniques, en particulier les mouvements électroniques de haute précision subissant des tests de précision pour l'obtention d'un certificat de chronomètre délivré par un organisme officiel (en Suisse : Le COSC). De manière plus générale, l'invention concerne les bases de temps comprenant un oscillateur à quartz et réglées par inhibition d'impulsions d'horloge et en particulier un procédé de réglage d'une telle base de temps.

<u>Arrière-plan technologique</u>

Les mouvements horlogers électroniques comprennent en général une base de temps fournissant un signal temporel et un module d'affichage recevant ce signal temporel, lequel est formé d'impulsions de cadencement. La base de temps comprend un circuit d'horloge et un circuit diviseur de fréquence. Le circuit d'horloge est formé par un oscillateur à quartz et il fournit un signal d'horloge au circuit diviseur de fréquence, ce signal d'horloge ayant une fréquence d'horloge déterminée. Le circuit diviseur de fréquence est formé par une chaîne de diviseurs (usuellement par deux) et il fournit en sortie un signal temporel formé d'impulsions de cadencement générées à une fréquence unité.

Comme il n'est pas possible dans une production industrielle de produire des oscillateurs ayant tous une fréquence de référence F0 qui permettrait d'obtenir des impulsions de cadencement avec une fréquence unité de référence (notamment 1 Hz), il est prévu de produire des oscillateurs à quartz avec des fréquences F réparties dans une certaine plage de fréquence supérieure à la fréquence de référence F0. Si on considère une période de base P0 (notamment une minute), le nombre d'impulsions d'horloge à la fréquence de référence est égal à M0 = P0·F0 (F0 est un nombre entier et on admet que P0 est aussi un nombre entier de secondes). Les oscillateurs à quartz sont sélectionnés de manière que le nombre d'impulsions X0 (nombre réel) qu'ils génèrent dans la période P0 est situé entre M0 et M0+N0max (c'est-à-dire M0 < X0 < M0+N0max). Pour ajuster au mieux le signal temporel généré par la base de temps, il est connu d'associer à cette base de temps un circuit d'inhibition, lequel fournit en entrée du circuit diviseur de fréquence un signal d'inhibition qui agit de manière à supprimer un nombre N0 d'impulsions d'horloge par période d'inhibition P0 pour ajuster sur chaque période d'inhibition P0 le nombre d'impulsions d'horloge activant le circuit diviseur de fréquence. Le nombre N0 est un nombre entier positif. Il est déterminé pour chaque circuit d'horloge de manière que le circuit diviseur de fréquence soit activé sur la période P0 un nombre de fois X0-N0 qui s'arrondit au nombre entier M0 (c'est-à-dire M0-1/2 < X0-N0 <= M0+1/2). Ainsi, la précision obtenue pour le mouvement horloger est égale à (1/2)/M0 = 1/2M0.

Pour augmenter la précision du mouvement horloger, il est possible d'augmenter la période d'inhibition P d'un facteur Y relativement à P0, soit P=Y·P0 avec Y>1. Sur cette période P, le nombre d'impulsions d'horloge M à la fréquence de référence est égal à Y·M0 (c'est-à-dire M = Y·M0) alors que le nombre X d'impulsions d'horloge à la fréquence F générées par un oscillateur à quartz donné est égal à Y·X0 (c'est-à-dire X = Y·X0). On remarquera que, pour les oscillateurs à quartz sélectionnés selon le critère mentionné précédemment, le nombre maximum d'impulsions d'horloge Nmax à inhiber sur la période P est égal à Y·N0max (c'est-à-dire Nmax = Y·N0max). A nouveau le nombre N d'impulsions d'horloge à inhiber est déterminé pour chaque oscillateur par la relation mathématique : M-1/2 < X-N <= M+1/2. Ainsi la précision obtenue par l'inhibition est donc égale à (1/2)/M = (1/2)/(Y·M0) = (1/Y)·(1/2M0). On constate donc que la précision sur une période d'inhibition augmente d'un facteur Y lorsque la période d'inhibition est augmentée par ce facteur Y. On notera que cette précision correspond à la précision moyenne de la base de temps qui donne la dérive de cette base de temps au cours du temps.

Cependant, l'augmentation de la période d'inhibition de P0 à P pose un problème exposé ci-après étant donné que l'erreur absolue maximale EAmax entre deux mesures du temps fournis par la base de temps augmente proportionnellement à Y puisque l'inhibition des N impulsions d'horloge par période d'inhibition est effectuée en bloc à intervalles de temps correspondant à la période d'inhibition. La définition classique de période d'inhibition découle d'ailleurs de cette manière de procéder. On a donc :

$$EAmax(P) = Nmax/F = Y\cdot N0max/F = Y\cdot EAmax(P0)$$

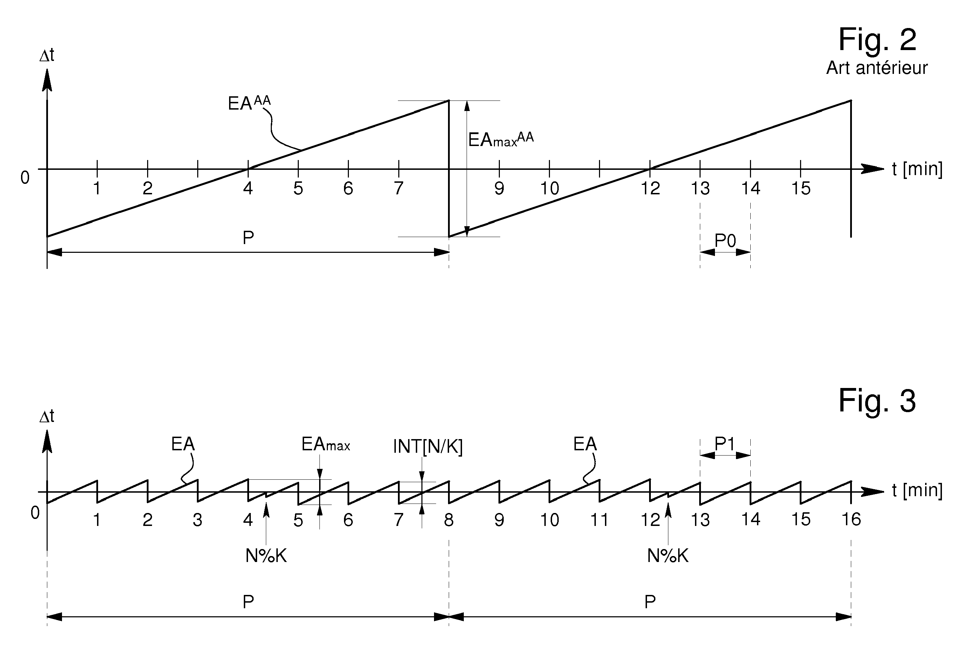

Ceci est représenté à la Figure 2 pour une période d'inhibition P de huit minutes (8 min). Soit P0 égal à une minute (1 min), l'erreur absolue maximale EAmax est proportionnelle à la période d'inhibition et cette erreur absolue maximale sur la période P est huit fois supérieure à l'erreur correspondante pour une période d'inhibition de base P0. L'erreur absolue instantanée ne pose pas de problème pour la marche du mouvement horloger et elle devient négligeable pour de longues périodes, mais elle pose un problème important lors de tests de précision de la base de temps ou du mouvement horloger comprenant une telle base de temps. Ainsi, lorsque l'on augmente la précision en augmentant la période d'inhibition, on ne peut la vérifier sur une courte période de sorte qu'il n'est pas possible d'obtenir un certificat de chronomètre très précis par un organisme de certification, notamment le COSC en Suisse. Les tests sont par exemple effectués sur des périodes d'environ 24 heures et ceci de manière asynchrone relativement aux périodes d'inhibition P. En d'autres termes, la période de test n'est pas déterminée de manière à être égale à un multiple de la période d'inhibition de sorte qu'il est possible de mesurer quasiment l'erreur absolue maximale sur cette période de test. L'erreur relative qui en résulte est relativement grande puisque la période de test est relativement courte. La mesure de la précision réelle du mouvement horloger ne peut donc pas être établie correctement par un organisme de certification.

### Résumé de l'invention

La présente invention a pour but de résoudre le problème de l'art antérieur susmentionné, à savoir permettre une augmentation de la précision d'un mouvement horloger électronique tout en assurant qu'il subisse avec succès des tests de certification établissant la grande précision de ce mouvement horloger.

La présente invention concerne un mouvement horloger électronique comprenant une base de temps agencée pour fournir un signal temporel formé d'impulsions de cadencement générées à une fréquence unité, cette base de temps comprenant :

- un circuit d'horloge fournissant des impulsions d'horloge avec une fréquence d'horloge déterminée ;
- un circuit diviseur de fréquence recevant à une première entrée les impulsions d'horloge et fournissant en sortie le signal temporel ;
- un circuit d'inhibition fournissant un signal d'inhibition à une deuxième entrée du circuit diviseur de fréquence, ce circuit d'inhibition étant agencé de manière que le signal d'inhibition supprime un premier nombre N d'impulsions d'horloge par période d'inhibition P pour régler sur chaque période d'inhibition le nombre d'impulsions d'horloge activant le circuit diviseur de fréquence de manière que ladite fréquence unité s'approche au plus près d'une fréquence unité de référence.

Selon la pratique industrielle, la fréquence d'horloge de ce mouvement horloger électronique est prévue dans une certaine plage de fréquence supérieure à une fréquence de référence qui permettrait d'obtenir une fréquence unité de référence en sortie du circuit diviseur de fréquence en l'absence d'inhibition.

Selon l'invention, chaque période d'inhibition est divisée en une pluralité K de sous-périodes et le circuit d'inhibition, pour effectuer ladite suppression des N impulsions d'horloge, est agencé de manière à supprimer dans chaque sous-période un deuxième nombre d'impulsions d'horloge correspondant au résultat de la division entière du premier nombre par le nombre de sous-périodes INT[N/K] et, en plus, dans chaque période d'inhibition un troisième nombre d'impulsions d'horloge correspondant au reste de ladite division entière (N modulo K).

L'invention concerne également un procédé de réglage d'une base de temps correspondant à l'algorithme implémenté dans le mouvement horloger selon l'invention.

Grâce aux caractéristiques de l'invention, il est possible d'augmenter la précision du mouvement horloger en augmentant la période d'inhibition P et de diminuer l'erreur absolue pour qu'elle corresponde sensiblement à celle d'une période d'inhibition plus courte d'un facteur K.

### Brève description des dessins

L'invention sera décrite ci-après en détail à l'aide de dessins annexés, donnés à titre d'exemples nullement limitatifs, dans lesquels :

- La Figure 1 représente schématiquement des blocs fonctionnels du mouvement horloger électronique selon l'invention ;
- La Figure 2, déjà décrite, est un graphe donnant l'erreur temporelle absolue au cours du temps pour un mouvement de l'art antérieur avec une période d'inhibition de huit minutes (8 min) ;
- La Figure 3 est un graphe similaire à celui de la Figure 2 et donnant l'erreur temporelle absolue au cours du temps pour un mouvement horloger électronique selon l'invention, également avec une période d'inhibition de huit minutes (8 min) ; et
- La Figure 4 montre une variante du procédé d'inhibition selon la Figure 3.

### Description détaillée de l'invention

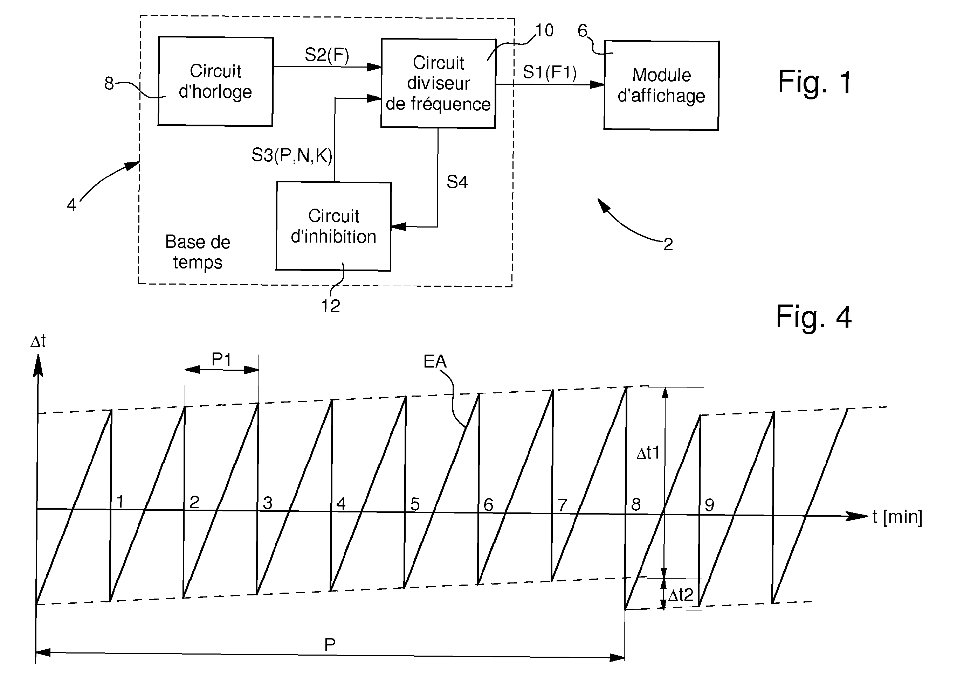

A la Figure 1 est représenté schématiquement un mouvement horloger électronique 2 comprenant une base de temps 4 agencée pour fournir un signal temporel S1 formé d'impulsions de cadencement générées à une fréquence unité F1. La base de temps comprend :

- un circuit d'horloge 8 qui fournit un signal d'horloge S2 formé d'impulsions d'horloge générées à une fréquence d'horloge déterminée F ;
- un circuit diviseur de fréquence 10 qui reçoit à une première entrée les impulsions d'horloge du signal d'horloge S2 et qui fournit en sortie le signal temporel S1 ;
- un circuit d'inhibition 12 qui fournit un signal d'inhibition S3 à une deuxième entrée du circuit diviseur de fréquence 10.

Pour synchroniser le circuit d'inhibition 12 avec le circuit d'horloge et également pour la gestion de l'envoi périodique du signal d'inhibition, ce circuit d'inhibition est relié au circuit diviseur de fréquence 10 qui lui fournit un signal de commande S4.

Comme déjà exposé précédemment, la fréquence d'horloge F est prévue dans une certaine plage de fréquence supérieure à une fréquence de référence F0 qui permettrait d'obtenir, en l'absence d'inhibition, une fréquence unité de référence en sortie du circuit diviseur de fréquence. La fréquence unité de référence est généralement de 1 Hz (période de 1 s).

Selon l'invention, le procédé de réglage implémenté dans le mouvement horloger selon l'invention comprend les étapes suivantes :

- sélectionner une période d'inhibition P supérieure à une minute ;
- déterminer un premier nombre N d'impulsions d'horloge à supprimer par période d'inhibition P pour régler sur chaque période d'inhibition P le nombre d'impulsions d'horloge activant le circuit diviseur de fréquence 10 de manière que la fréquence unité F1 s'approche au plus près de la fréquence unité de référence susmentionnée ;
- sélectionner une pluralité K de sous-périodes P1 pour chaque période d'inhibition P ;
- supprimer dans chaque sous-période P1 un deuxième nombre N1 d'impulsions d'horloge correspondant au résultat de la division entière du premier nombre N d'impulsions d'horloge par le nombre K de sous-périodes (N1= INT[N/K]), et
- supprimer, en plus de la suppression de l'étape précédente, dans chaque période d'inhibition P un troisième nombre N2 d'impulsions d'horloge correspondant au reste de la division entière du premier nombre N d'impulsions d'horloge par le nombre K de sous-périodes (N2 = N modulo K).

Ainsi, sur chaque période d'inhibition P, on supprime bien le premier nombre N permettant d'obtenir la précision maximale pour cette période d'inhibition. En effet, N = N1 + N2.

La Figure 3 montre le bénéfice du procédé de réglage de la base de temps 4 selon la présente invention. Dans l'art antérieur, il est usuel de prévoir une période d'inhibition P0 égale à une minute (P0 = 1 min). Pour augmenter la précision, on peut prendre une période d'inhibition P plus longue, par exemple de huit minutes (P = 8 min), comme dans la variante de l'art antérieur représentée à la Figure 2. En prenant le cas spécifique où le réglage de la base de temps par inhibition d'impulsions d'horloge sur la période P permet d'obtenir exactement la fréquence unité de référence, l'erreur absolue instantanée $EA^{AA}$ varie avec une pente donnée par (N/P)/F, N étant le nombre d'impulsions d'horloge à supprimer par période P et F la fréquence d'horloge. Ainsi, dans le cas de l'art antérieur, l'erreur absolue maximale $EAmax^{AA}$ sur une période P (entre le début et la fin de la période) est égale à N/F. Dans le cas où N = Nmax, on arrive à une erreur absolue maximale égale à Nmax/F sur la période P. Dans le cas spécifique susmentionné, on notera que N = Y·N0 où N0 est le nombre d'impulsions à supprimer sur une période de base P0 = P/Y. De manière générale, Nmax = Y·N0max.

La Figure 3 donne l'erreur absolue EA avec le procédé de réglage selon l'invention pour une période d'inhibition P correspondant à celle du cas de l'art antérieur de la Figure 2. En prenant K=8 et donc une sous-période P1 = 1 min, l'erreur absolue maximale EAmax entre deux instants quelconques d'une période P est fortement diminuée. Elle est sensiblement donnée par l'égalité et l'inégalité suivantes :

$$EAmax = (INT[N/K] + N \text{ modulo } K) / F$$

$$EAmax < (INT[N/K] + K) / F$$

On remarquera qu'à la Figure 3, N modulo K est noté N%K. A titre d'exemple, P1 est choisi égal à la période de base P0, mais c'est un cas particulier nullement limitatif. On peut notamment prendre K=4 et P1= 2 min pour une période P= 8 minutes, ou K=16 et P1= 30 secondes (30 s).

Dans le cas spécifique susmentionné, EAmax = INT[N/K] = N0 et EAmax correspond à l'erreur absolue maximale entre deux instants quelconques au cours du temps. Pour illustrer le cas général, prenons un exemple numérique, soit P= 8 min, K=8 et N=245. Ainsi, dans le cas de l'art antérieur (Figure 2), l'erreur absolue maximale $EAmax^{AA}$ = 245/F. Dans le cas de la présente invention, la sous-période P1 = 1 min, INT[N/K] = 30 et N modulo K = 5. Ainsi l'erreur absolue maximale EAmax = (30+5)/F = 35/F. Selon l'inégalité donnée ci-avant EAmax < (INT[N/K] +K) / F = 38/F. On voit donc que dans le pire des cas, l'erreur absolue maximale est diminuée d'au moins un facteur six.

A la Figure 3, la correction du reste de la division entière sur la période P (N modulo K, noté N%K) est effectuée à l'intérieur d'une seule sous-période P1 (sous-périodes No 5, 13,... 5+nK,...) dans chaque période d'inhibition P, alors que la correction de INT[N/K] impulsions d'horloge est effectuée à la fin ou au début de chaque sous-période P1. A la Figure 4 est montrée de manière plus détaillée une variante de mise en oeuvre du procédé de réglage selon l'invention où la correction du reste de la division entière N modulo K sur la période P est effectuée ensemble avec une correction de INT[N/K] impulsions d'horloge à la fin ou au début d'une sous-période P1. Dans la variante de la Figure 4, $\Delta t1$ = (INT[N/K])/F et $\Delta t2$ = (N modulo K)/F. On a pris un exemple où $\Delta t2$ est non nul et environ égal à un sixième de $\Delta t1$ comme dans l'exemple numérique donné précédemment. Comme la correction $\Delta t1$ dans chaque sous-période P1 est relativement peu précise puisque N modulo K est non nul, on constate qu'il y a une dérive au cours de chaque période d'inhibition P définie par les lignes en trait interrompu. Cette dérive est compensée en fin de la période d'inhibition P de sorte que la fréquence moyenne de la base de temps est identique à celle que l'on obtient dans une réalisation de l'art antérieur avec une même période d'inhibition P. Comme mentionné précédemment, l'erreur absolue maximale EAmax = $\Delta t1 + \Delta t2$.

De préférence, étant donné qu'on travaille généralement avec des registres binaires dans un circuit digital, on sélectionne K = $2^n$, n étant un nombre entier supérieur à un (n>1). Le nombre N a un maximum Nmax donné par la tolérance de fabrication des oscillateurs à quartz. N est un nombre entier enregistré sous forme binaire dans un registre mémoire. Par exemple Nmax = 1023. Comme $2^{10}$ = 1024, le registre mémoire comprend alors 10 bits. De manière générale, prenons $2^n$ < Nmax < $2^m$, m étant par définition supérieur à n dans le cadre de l'invention (m>n). Ainsi, les deux nombres d'impulsions à supprimer qu'il faut déterminer pour la mise en oeuvre du procédé de réglage de la base de temps, soit INT[N/K] et N modulo K, s'obtiennent aisément. En effet, d'une part, INT[N/K] correspond au nombre binaire obtenu en prenant les m-n premiers bits du registre mémoire, ce qui revient à décaler le nombre binaire dans le registre mémoire de m-n bits vers la droite. D'autre part, N modulo K est donné par les n derniers bits du registre mémoire.

## Revendications

**1.** Mouvement horloger électronique (2) comprenant une base de temps (4) agencée pour fournir un signal temporel (51) formé d'impulsions de cadencement générées à une fréquence unité (F1), cette base de temps comprenant :

- un circuit d'horloge (8) fournissant des impulsions d'horloge avec une fréquence d'horloge déterminée (F) ;
- un circuit diviseur de fréquence (10) recevant à une première entrée lesdites impulsions d'horloge et fournissant en sortie ledit signal temporel ;
- un circuit d'inhibition (12) fournissant un signal d'inhibition (S3) à une deuxième entrée dudit circuit diviseur de fréquence, ce circuit d'inhibition étant agencé de manière que le signal d'inhibition supprime un premier nombre N d'impulsions d'horloge par période d'inhibition (P) pour régler sur chaque période d'inhibition le nombre d'impulsions d'horloge activant ledit circuit diviseur de fréquence de manière que ladite fréquence unité s'approche au plus près d'une fréquence unité de référence ;

ladite fréquence d'horloge étant prévue dans une certaine plage de fréquence supérieure à une fréquence de référence qui permettrait d'obtenir, en l'absence d'inhibition, ladite fréquence unité de référence en sortie du circuit diviseur de fréquence ;

**caractérisé en ce que** chaque période d'inhibition est divisée en une pluralité K de sous-périodes (P1), et **en ce que** le circuit d'inhibition, pour effectuer ladite suppression des N impulsions d'horloge, est agencé de manière à supprimer dans chaque sous-période un deuxième nombre N1 d'impulsions d'horloge correspondant au résultat de la division entière du premier nombre par le nombre de sous-périodes (N1= INT[N/K]) et, en plus, dans chaque période d'inhibition un troisième nombre N2 d'impulsions d'horloge égal au reste de ladite division entière (N2 = N modulo K).

**2.** Mouvement horloger électronique selon la revendication 1, **caractérisé en ce que** le nombre K de sous-périodes est égal à une puissance entière de deux, soit K = $2^n$, n étant un nombre entier supérieur à zéro (n>0) et le nombre K étant inférieur à un nombre maximum d'impulsions d'horloge à supprimer par période d'inhibition (P).

**3.** Mouvement horloger électronique selon la revendication 1 ou 2, **caractérisé en ce que** le nombre entier n est supérieur à deux (n>2).

**4.** Mouvement horloger électronique selon l'une quelconque des revendications 1 à 3, **caractérisé en ce que** la période d'inhibition (P) est supérieure ou égale à huit minutes (P>= 8 min).

**5.** Procédé de réglage d'une base de temps (4) agencée pour fournir un signal temporel (S1) formé d'impulsions de cadencement générées à une fréquence unité (F1), cette base de temps comprenant :

   - un circuit d'horloge (8) fournissant des impulsions d'horloge avec une fréquence d'horloge déterminée (F) ;
   - un circuit diviseur de fréquence (10) recevant à une première entrée lesdites impulsions d'horloge et fournissant en sortie ledit signal temporel ;
   - un circuit d'inhibition (12) fournissant un signal d'inhibition (S3) à une deuxième entrée dudit circuit diviseur de fréquence ;
   ladite fréquence d'horloge étant prévue dans une certaine plage de fréquence supérieure à une fréquence de référence qui permettrait d'obtenir, en l'absence d'inhibition, une fréquence unité de référence en sortie du circuit diviseur de fréquence ;
   ce procédé de réglage comprenant les étapes suivantes :
   - sélectionner une période d'inhibition (P) supérieure à une minute ;
   - déterminer un premier nombre N d'impulsions d'horloge à supprimer par période d'inhibition (P) pour régler sur chaque période d'inhibition le nombre d'impulsions d'horloge activant ledit circuit diviseur de fréquence de manière que ladite fréquence unité s'approche au mieux de ladite fréquence unité de référence ;
   - sélectionner une pluralité K de sous-périodes (P1) pour chaque période d'inhibition (P) ;
   - supprimer dans chaque sous-période (P1) un deuxième nombre N1 d'impulsions d'horloge correspondant au résultat de la division entière du premier nombre par le nombre de sous-périodes (N1= INT[N/K]), et
   - supprimer, en plus de la suppression de l'étape précédente, dans chaque période d'inhibition (P) un troisième nombre N2 d'impulsions d'horloge correspondant au reste de ladite division entière (N2 = N modulo K).

**6.** Procédé de réglage selon la revendication 5, **caractérisé en ce que** le nombre K de sous-périodes est égal à une puissance entière de deux, soit $K = 2^n$, n étant un nombre entier supérieur à zéro (n>0) et le nombre K étant inférieur à un nombre maximum d'impulsions d'horloge à supprimer par période d'inhibition (P).

**7.** Procédé de réglage selon la revendication 5 ou 6, **caractérisé en ce que** le nombre entier n est supérieur à deux (n>2).

**8.** Procédé de réglage selon l'une quelconque des revendications 5 à 7, **caractérisé en ce que** la période d'inhibition (P) est supérieure ou égale à huit minutes (P>= 8 min).

EP 2 738 629 A1

Fig. 1

Base de temps **4**

Circuit d'horloge **8**

S2(F) →

Circuit diviseur de fréquence **10**

S1(F1) →

Module d'affichage **6**

S3(P,N,K)

S4

Circuit d'inhibition **12**

**2**

Fig. 4

Δt

P1

EA

Δt1

Δt2

1  2  3  4  5  6  7  8  9

t [min]

P

Fig. 2
Art antérieur

$\Delta t$

$EA^{AA}$

$EA_{max}^{AA}$

0   1   2   4   5   6   7   9   10   12   13   14   15   t [min]

P

P0

Fig. 3

$\Delta t$

EA   $EA_{max}$   INT[N/K]   EA   P1

0   1   2   3   4   5   6   7   8   9   10   11   12   13   14   15   16   t [min]

N%K   N%K

P   P

EP 2 738 629 A1

**EP 2 738 629 A1**

Europäisches
Patentamt

European
Patent Office

Office européen
des brevets

## RAPPORT DE RECHERCHE EUROPEENNE

Numéro de la demande

EP 13 19 1860

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 4 068 462 A (DUFF DONALD R ET AL) 17 janvier 1978 (1978-01-17) * figures 2,5 * * colonne 3, ligne 10 - colonne 7, ligne 4 * ----- | 1-8 | INV. G04G3/02 |
| X | US 2009/180358 A1 (KOUZUMA SHINICHI [JP]) 16 juillet 2009 (2009-07-16) * alinéas [0036] - [0042] * * alinéas [0069] - [0087] * ----- | 1-8 | |
| A | US 4 075 827 A (YOSHIDA MAKOTO ET AL) 28 février 1978 (1978-02-28) * figures 1-4 * * colonne 2, ligne 63 - colonne 4, ligne 50 * ----- | 1-8 | |
| A | US 4 101 838 A (AIHARA MITSUO ET AL) 18 juillet 1978 (1978-07-18) * colonne 4, ligne 58 - colonne 7, ligne 61 * * figures 3,5,6 * ----- | 1-8 | DOMAINES TECHNIQUES RECHERCHES (IPC) G04G |
| A | GB 2 002 157 A (FAIRCHILD CAMERA INSTR CO) 14 février 1979 (1979-02-14) * le document en entier * ----- | 1-8 | |
| A | FR 2 197 265 A1 (DYNACORE SA [CH]) 22 mars 1974 (1974-03-22) * le document en entier * ----- | 1-8 | |

Le présent rapport a été établi pour toutes les revendications

| Lieu de la recherche | Date d'achèvement de la recherche | Examinateur |
|---|---|---|
| La Haye | 10 janvier 2014 | Pirozzi, Giuseppe |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons

.......................................................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 13 19 1860

La présente annexe indique les membres de la famille de brevets relatifs aux documents brevets cités dans le rapport de recherche européenne visé ci-dessus.
Lesdits membres sont contenus au fichier informatique de l'Office européen des brevets à la date du
Les renseignements fournis sont donnés à titre indicatif et n'engagent pas la responsabilité de l'Office européen des brevets.

10-01-2014

| Document brevet cité au rapport de recherche | | Date de publication | Membre(s) de la famille de brevet(s) | | Date de publication |
|---|---|---|---|---|---|
| US 4068462 | A | 17-01-1978 | AUCUN | | |
| US 2009180358 | A1 | 16-07-2009 | JP | 5114218 B2 | 09-01-2013 |
| | | | JP | 2009165069 A | 23-07-2009 |
| | | | US | 2009180358 A1 | 16-07-2009 |
| US 4075827 | A | 28-02-1978 | DE | 2633471 A1 | 10-02-1977 |
| | | | GB | 1554270 A | 17-10-1979 |
| | | | JP | S5218363 A | 10-02-1977 |
| | | | JP | S6024433 B2 | 12-06-1985 |
| | | | US | 4075827 A | 28-02-1978 |
| US 4101838 | A | 18-07-1978 | CH | 618832 A | 29-08-1980 |
| | | | GB | 1569944 A | 25-06-1980 |
| | | | JP | S5291471 A | 01-08-1977 |
| | | | US | 4101838 A | 18-07-1978 |
| GB 2002157 | A | 14-02-1979 | DE | 2833653 A1 | 15-02-1979 |
| | | | GB | 2002157 A | 14-02-1979 |
| | | | JP | S5428561 A | 03-03-1979 |
| FR 2197265 | A1 | 22-03-1974 | CH | 610473 B5 | 30-04-1979 |
| | | | CH | 619106 A | 15-09-1980 |
| | | | CH | 1257072 A4 | 30-04-1976 |
| | | | DE | 2342701 A1 | 14-03-1974 |
| | | | FR | 2197265 A1 | 22-03-1974 |
| | | | GB | 1416941 A | 10-12-1975 |
| | | | HK | 62476 A | 15-10-1976 |

EPO FORM P0460

Pour tout renseignement concernant cette annexe : voir Journal Officiel de l'Office européen des brevets, No.12/82